Europäisches Patentamt

European Patent Office

Office européen des brevets

(19)

(11) Publication number: **0 241 721 B1**

(12) # EUROPEAN PATENT SPECIFICATION

(45) Date of publication of patent specification: **23.09.92**

(51) Int. Cl.5: **H01L 23/48**, C23C 30/00, H01B 1/02

(21) Application number: **87103688.5**

(22) Date of filing: **13.03.87**

(54) Conductor and method of producing the same.

(30) Priority: **18.03.86 JP 61898/86**
**05.06.86 JP 131624/86**
**06.06.86 JP 132434/86**

(43) Date of publication of application:
**21.10.87 Bulletin  87/43**

(45) Publication of the grant of the patent:
**23.09.92 Bulletin  92/39**

(84) Designated Contracting States:
**DE FR GB**

(56) References cited:
**DE-A- 2 937 783**
**DE-C- 314 791**
**GB-A- 1 007 260**
**GB-A- 1 425 754**
**GB-A- 1 489 510**

**PATENT ABSTRACTS OF JAPAN, vol. 9, no. 230 (E-343)[1953], 17th September 1985; & JP-A-60 85 546**

**PATENT ABSTRACTS OF JAPAN, vol. 10, no. 168 (E-411)[2224], 14th June 1986; & JP-A-61 18 163**

(73) Proprietor: **SUMITOMO ELECTRIC INDUS-TRIES, LTD.**
**5-33, Kitahama 4-chome, Chuo-ku**
**Osaka-shi, Osaka 541(JP)**

(72) Inventor: **Sawada,Kazuo Osaka Works**
**Sumitomo Electric Ind., Ltd. 1-3 Shimaya**
**1-chome**
**Konohana-ku Osaka(JP)**
Inventor: **Nishio, Masanobu Osaka Works**
**Sumitomo Electric Ind., Ltd. 1-3 Shimaya**
**1-chome**
**Konohana-ku Osaka(JP)**
Inventor: **Nakai, Yoshihiro Osaka Works**
**Sumitomo Electric Ind., Ltd. 1-3 Shimaya**
**1-chome**
**Konohana-ku Osaka(JP)**

(74) Representative: **Patentanwälte Kirschner & Grosse**
**Forstenrieder Allee 59**
**W-8000 München 71(DE)**

Rank Xerox (UK) Business Services

## Description

BACKGROUND OF THE INVENTION

Field of the Invention

This invention relates to a conductor which is required to be small in diameter and high in quality, such as a copper wire used as a magnet wire, a conductor used in acoustic and image-forming appliances such as stereos and VTRs, and a bonding wire used for connecting semiconductor elements such as integrated circuits and transistors, and it also relates to a method of producing the same.

Description of the Prior Art

Conventionally, in producing thin metal wires, first an ingot is prepared. The ingot is then subjected to multistage hot and cold working a number of times until a thin wire of desired size is obtained.

As a variation thereof, there is a dip forming process as described, for example, on pages 980-987 of Report No. 12, Vol., 21 (1982) from the Japan Institute of Metals. In this process, a core wire is passed at high speed through a crucible containing molten copper, whereby said core wire is thickened as the molten copper sticking thereto solidifies. Thereafter, the core material is rolled to produce a roughly drawn wire.

The conventional methods described above were each developed as suitable methods for mass production (for example, several tons/hour to tens of tons/hour). Thus, they cannot always be said to be suitable methods, from the standpoint of quality, quality control and processability, for producing wires such as conductors used for modern electronics which requires high purity, high quality and severe thinning.

That is, when metal is melted in large amounts, it is impossible to prevent contamination of foreign matter. Further, hot working often causes foreign matter to enter in the vicinity of the metal surface. In the field of very thin wires, wire breakage forms a major factor which impedes productivity. It has been found that most of the wire breaks are caused by foreign matter such as ceramics and iron powders contaminating into the metal during melting and casting or working. Further, multistage wire drawing process makes complicated the control of lubricants, dies, and wire drawing machines.

For conductors used for wiring acoustic and image-forming appliances such as stereos and VTRs, it is considered desirable that conductors contain a miniumum of dissimilar elements including such components as oxygen. However, it is difficult to maintain the entire conductor in the state of high purity copper. The reason is that if, for example, an ingot of high purity copper is remelted or cast, dissimilar elements or foreign matter often contaminates into the metal during processing, thus making it impossible to maintain the high purity. After all, when conventional conductors for acoustic and image-forming appliances are used, it has been impossible to obtain sounds or images of good quality.

It is required that bonding wires for connecting semiconductor elements be small in diameter and high in quality and reliable. Conventionally, as for this type of bonding wires, thin wires of gold, aluminum or copper have been practically used or investigated for practical use. In the case of a thin wire of gold, its connecting property is good, but there is a problem of high cost. In recent years, to reduce cost by avoiding the use of noble metals, bonding wires of aluminium, aluminum alloy, copper or copper alloy have been given attention, being about to be put into practical use. In the case of a bonding wire to be used for connection, contamination of foreign matter should be avoided to maintain the good connecting property. That is, it is considered desirable to use high purity metal in making bonding wires.

However, high purity metal itself is of high cost. Further, its drawing property is poor because of its lack of strength. For example, in the case of a bonding wire of high purity aluminum, because of its low recrystallization temperature, it is recrystallized by the heat of friction produced during drawing. Further, if an ingot for bonding wires made of high purity metal is remelted and cast, there is the danger of foreign matter contaminating into the metal during processing, thus making it impossible to maintain the high purity.

The following prior art documents relate to the production of high quality thin wires.

In JP-A-61-18163 there is described a method for improving the corrosion resistance of a bonding wire by applying aluminium on the surface of an aluminium alloy containing a transition element as a core. These wires are used in IC components.

A method for preparing an Au-wire with a high ductility and a high hardness is shown in JP-A-60-85546 and is based on the idea to coat a hard core material with impurities with a cylindrical and concentric material of high purity and thereby high extensibility.

Furthermore in GB-A- 1 007 260 there is disclosed a wire which comprises a core being for instance of a copper/beryllium alloy around which a coating for instance of copper in cast in order to modify the mechanical and electrical properties of the product.

The DE-C-314791 discloses the treatment of metal products, particulary of wires, by vapor deposition of a pure metal on a core of the same metal and by drawing the coated wire to the desired diameter with the aim to get homogeneous wires or compositions of normally not alloyable components. The steps of coating and drawing may be alternately performed a plurality of times.

## SUMMARY OF THE INVENTION

An object of this invention is to provide a production method capable of obtaining a thin metal wire of high purity and high quality while preventing contamination of foreign matter during production.

Another object of the invention is to provide a bonding wire for connecting semiconductor elements, which is of low cost and superior in drawing property and capable of maintaining its good connecting property, and to provide a method of producing the same.

A further object of the invention is to provide a conductor for acoustic and image-forming appliances, which is capable of obtaining sounds and images of good quality, and to provide a method of producing the same.

A thin wire conductor obtained by the invention is characterized by the features given in claim 1.

The method of producing the thin wire conductor according to the invention is characterized by the features given in claim 2.

A preferred embodiment of the method is given by claim 3.

The coating by vapor phase method, as compared with that obtained by other coating methods, make it easy to attain high quality and cleanliness. Therefore, if a wire whose surface has been coated with a clean metal having no foreign matter is drawn by plastic working until it becomes a thin wire of predetermined size, a thin metal wire of high purity and high quality can be obtained with less occurrence of wire breakage.

Coating by vapor phase method and plastic working may be alternately performed a number of times. More particularly, the surface of core in the form of a portion or the whole of the thin metal wire of high purity and high quality obtained by the method described above is coated again with the same kind of metal by vapor phase method. Thereafter, this wire is drawn by plastic working. If this process is repeated once or a number of times, a very thin wire of high purity and high quality can be obtained. In this case, contamination of foreign matter rarely occurs and so does wire breakage.

According to the invention the number of process steps by plastic working can be reduced. For this reason, if the invention is used for production of thin wires of less than 30 $\mu$m, which should be called very thin wires, process control can be facilitated because of a reduced number of processes involved. Further, processability is good with no excessive force involved in wire drawing, so that efficiency of production is high. Further, the coating metal can be easily made pure to a great degree.

With the arrangement thus made, the wire obtained is electrochemically stable and the danger of corrosion on the end surfaces can be reduced. Further, the adhesion between the core and the deposited coating material is improved.

As for coating by vapor phase method, physical vapor deposition, such as a sputtering, or chemical vapor deposition, such as plasma CVD method, can be used. If coating is effected by sputtering, a wide variety of materials can be deposited on the core wire with high adhesive strength. Coating by chemical vapor deposition uses a gas which can be easily refined, so that deposition with high purity and high quality is possible.

As for plastic working subsequent to metal coating by vapor phase method, industrially, wire drawing using a drawing die in the cold is convenient. The use of a drawing die enables plastic working to be performed while enhancing the adhesion between the core and the deposited coating material. In this case, plastic working in one process is performed so that the percentage reduction in the cross-sectional area is within the range of 20-90 %. Plastic working with a percentage reduction of less than 20 % would decrease efficiency of production. On the other hand, plastic working with a percentage reduction of more than 90 % would impair the softness and elongation property of the resulting wire. Further, it is sometimes difficult to perform plastic working with a percentage reduction of more than 90 % for each deposition.

The invention, which achieves the merits described above, is effectively employed for the production of bonding wires for connecting semiconductor elements, conductors for wiring image-forming and acoustic appliances, and magnet wires of copper or aluminum.

The conductor for acoustic and image-forming appliances is in the form of a copper wire of 99.99 % or above purity whose surface has been coated with copper of 99.999 % or above purity.

High frequency signal currents in acoustic and image-forming appliances flow in the vicinity of the surface of a conductor because of the skin effect. According to the embodiment described above, the core is made of copper of 99.99 % or above purity, while the surface area through which high frequency current flows is made of high purity copper of 99.999 % or above. Therefore, high frequency current flows under a low AC resistance, without the possibility of a phase difference being caused by the effects of impurity elements. Thus, the use of a conductor for acoustic and image-forming appliances according to the invention makes it possible to obtain sounds and images of good quality.

According to the method of the invention, copper of 99.999 % or above purity is used for coating by vapor phase method. In the case of coating by vapor phase method, as compared with other coating methods, control of high purity and cleanliness is easy. Therefore, the surface of the core can be easily coated with copper of high purity and high quality containing no foreign matter. As for coating by vapor phase method, physical deposition, such as sputtering, or chemical deposition, such as plasma CVD method, can be employed.

Subsequently to coating with copper of high purity by vapor phase method, cold working is performed so that the percentage reduction in cross-sectional area is within the range of 20-90 %. This cold working ensures that sounds and images obtained are of high quality. In the case of a percentage reduction of less than 20 %, improvement in sounds and images would be insufficient. Such improvement will be substantially saturated at a percentage reduction of about 90 %. Thus, with a percentage reduction of more than 90 %, satisfactory improvement could not be expected; rather, there would be the danger of flexibility being impaired.

The bonding wire for wiring semiconductor elements obtained by the invention is in the form of a thin metal wire of copper, aluminum or gold whose surface has been coated with the same kind of metal of higher purity. Therefore, this bonding wire will exhibit a good connecting property. As compared with a bonding wire made entirely of high purity metal, the bonding wire of the invention has its surface alone made of high purity metal, so that it is of low cost and superior in drawing property. Thus, the inner metal of relatively low purity contributes to lowering cost and increasing strength.

The coating metal of relatively high purity contributes to improving the connecting property of the bonding wire. In this connection, to ensure a good connecting property, the coating metal is of 99.999 % or above purity. Coating with a metal of relatively high purity is performed by a vapor phase method and wire drawing. As for coating by vapor phase method, physical deposition, such as sputtering, or chemical deposition, such as plasma CVD method, can be employed.

Coating by vapor phase method and subsequent wire drawing may be alternately performed a plurality of time. In this case, contamination of foreign matter rarely occurs and so does wire breakage. Further, processability is good with no excessive force involved in wire drawing, so that efficiency of production is high. As for plastic working subsequent to metal coating by vapor phase method, industrially, wire drawing using a drawing die in the cold is convenient. The use of a drawing die enables plastic working to be performed while enhancing the adhesion between the core and the deposited coating material.

These objects and other objects, features, aspects and advantages of thepresent invention will become more apparent from the following detailed description of the present invention when taken in conjunction with the accompanying drawings.

BRIEF DESCRIPTION OF THE DRAWINGS

Fig. 1 is a schematic view of an apparatus for performing coaxial magnetron sputtering method;

Fig. 2 is a schematic view of an apparatus for performing vacuum vapor deposition and wire drawing with a die;

Fig. 3 is a sectional view of a wire obtained according to the invention;

Fig. 4 is a sectional view of a twisted wire conductor using a conductor 101 shown in Fig. 3; and

Fig. 5 is a sectional view of a tape-like conductor obtained according to the invention,

DESCRIPTION OF THE PREFERRED EMBODIMENTS

Example 1

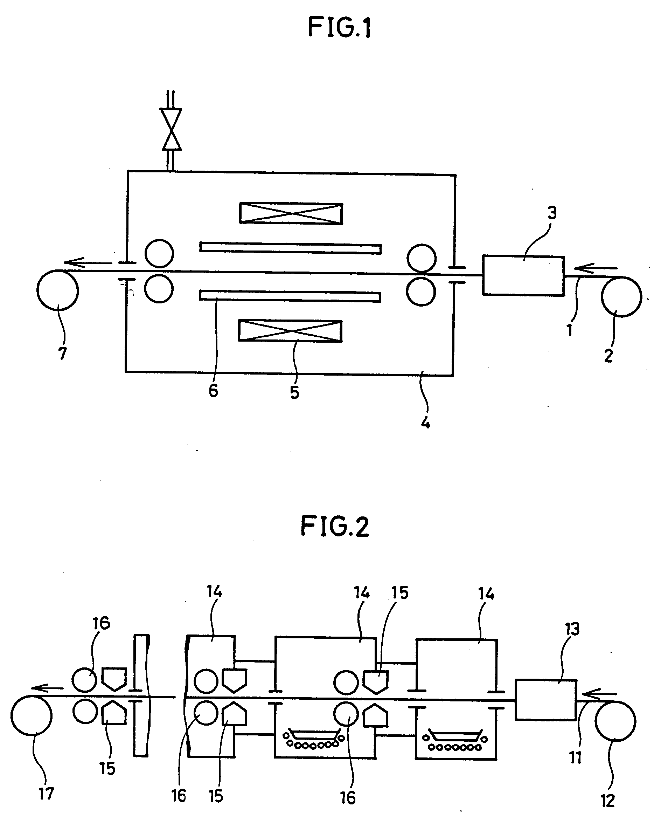

Using an apparatus shown in Fig. 1, the surface of a wire of 20 $\mu$m in diameter with a clean surface was coated with copper by coaxial magnetron sputtering method to provide a round wire of 30 $\mu$m in outer diameter. In Fig. 1, the numeral 1 denotes a core wire; 2 denotes a supply mechanism; 3 denotes a preparatory processing mechanism; 4 denotes a continuous sputtering unit; 5 denotes a magnet; 6 denotes a target; and 7 denotes a winding mechanism.

Said round wire was drawn again using a cold working die to change its diameter to 20 $\mu$m. The degree of cold working was 56 %. The wire drawing was smoothly effected with very few wire breaks. The weight per wire break was 5.3 times as much as when drawing a material obtained by a conventional method. Further, according to the method used in this example, the yield was high.

The surface of the wire of 20 $\mu$m in diameter formed in the manner described above was coated with copper by sputtering to change its outer diameter to 30 $\mu$m, whereupon the wire was drawn to change its diameter 20 $\mu$m. The result was the same as described above.

Example 2

Enamel was applied by baking to the surface of the copper wire of 20 μm in diameter obtained in Example 1, whereby the wire was processed into a magnet wire. The magnet wire thus obtained had a good elongation property. That is, whereas the elongation of a magnet wire obtained by a conventional method was 16 %, the magnet wire obtained by the invention exhibited an elongation value of as high as 20 % while having substantially the same strength as said magnet wire obtained by a conventional method.

## Example 3

Using an apparatus shown in Fig. 2, an aluminum wire of 100 μm in diameter was produced. In Fig. 2, the numeral 11 denotes a core wire; 12 denotes a supply mechanism; 13 denotes a preparatory processing unit; 14 denotes a die; 16 denotes a driving mechanism; and 17 denotes a winding mechanism.

Concretely, while cleaning the surface of an aluminum wire of 100 μm in diameter having a purity of 99.99 %, aluminum of 99.999 % purity was continuously deposited on said surface by vacuum vapor deposition until the wire diameter was 110 μm. This wire was continuously drawn through a die to reduce its diameter to 100 μm. Thereafter, the wire was subjected to vapor deposition and drawing repetitively, in the same manner, while continuously cleaning its surface. The number of times of vapor deposition and drawing performed was 5; finally, an aluminum wire of 100 μm in diameter was obtained.

The aluminum wire thus obtained was used as a bonding wire for wiring semiconductor elements; the bonding wire was found to exhibit a good corrosion resistance and bonding characteristic.

## Example 4

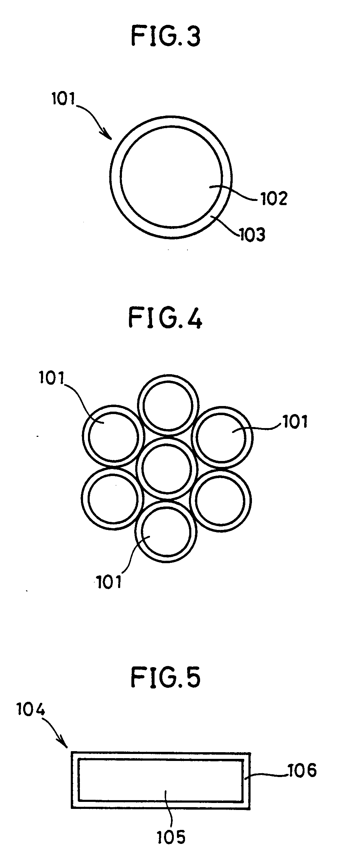

The surface of a copper wire of 99.99 % purity was coated with copper of 99.999 % by vacuum vapor deposition. The conductor thus obtained was cold-worked using a die so that the percentage reduction in cross-sectional area was 70 %. Fig. 3 shows the cross section of the wire 101 thus obtained. The core 102 is copper of 99.99 %, while the surface area 103 is copper of 99.999 %. The outer diameter is 0.12 mm and the thickness of the coating of high purity copper is 0.01 mm.

To use this conductor 101 for wiring a VTR, 7 such conductors were twisted together to form an electrical wire, as shown in Fig. 4. The sounds and images of the VTR were compared with those obtained by an electrical wire formed of conductors of the same diameter made of a soft material of conventional oxygen-free copper. It was found that when the conductor 101 which is an example of the invention obtained in the manner described above was used, the sounds were very rich and clear and the images were clear.

## Example 5

The surface of a copper wire of 99.99 % was coated with copper of 99.999 % by plasma CVD method to provide a tape-like conductor 104 as shown in Fig. 5. The conductor was then punched and used as a lead for transistors in stereos. As compared with a lead of conventional oxygen-free copper, this lead provided clear sounds and sound effects of good quality.

## Example 6

The surface of a copper wire of 90 μm in diameter having a purity of 99.99 % was coated with copper of 99.9998 % purity by sputtering until its diameter was 100 μm. It was then drawn until its diameter was 25 μm for use as a bonding wire. This bonding wire was bonded to an Al vapor deposition electrode by ball bonding method making a ball by arc discharge method in an Ar atmosphere. It was found that the wedge bonding area between the bonding wire and the ball bonding area and the wedge bonding area between the bonding wire and an Al-plated lead frame portion were both superior in bonding characteristic.

## Claims

1.  A thin wire electrical conductor comprising a core metal conductor and a conductive metal coating on said core metal conductor, wherein said core metal conductor is made of a metal selected from the group consisting of copper, aluminum and gold,
    said conductive metal coating is made of the same metal as said core metal conductor and has a higher purity than said core metal conductor,
    said core metal conductor has a purity of at least 99.99%,
    said conductive metal coating has a purity of at least 99.999%, and
    said electrical conductor comprising the core metal conductor and the conductive metal coating has an outer diameter within the range of about 20 μm to about 127 μm.

2.  A method of producing a thin wire electrical conductor having a determined final diameter, comprising the steps of
    a) forming a core metal conductor of pure metal selected from the group consistng of copper, aluminium and gold having a plurity of at least 99.99%, said core metal conductor having an initial diameter,

b) depositing by a vapor phase method on said core metal conductor a conductive metal coating of the same metal as that of said core metal conductor having a higher purity than the metal of said core metal conductor, its purity being at least 99.999%, to form a coated wire having a second diameter being larger than said initial diameter of said core metal conductor, and

c) cold deforming said coated wire for plastically reducing the diameter of said coated wire, thereby achieving a percentage reduction in the cross-sectional area of the coated wire within a range of 20-90%, to form a finished wire having said final diameter which is within the range of about 20 $\mu$m to about 127 $\mu$m.

3. A method as set forth in claim 2, wherein said depositing of said conductive metal coating and said cold deforming steps are alternately performed a plurality of times.

**Patentansprüche**

1. Einen dünnen Draht aufweisender elektrischer Leiter, der einen Metall-Kernleiter und eine leitende Metall-Beschichtung auf dem Metall-Kernleiter aufweist, wobei

- der Metall-Kernleiter aus einem Metall hergestellt ist, das aus der Gruppe aus Kupper, Aluminium und Gold ausgewählt ist,

- die leitende Metallbeschichtung aus dem gleichen Metall wie der Metall-Kernleiter hergestellt ist und eine höhergradige Reinheit wie der Meallkernleiter hat,

- der Metall-Kernleiter eine Reinheit von wenigstens 99,99 % hat,

- die leitende Metallbeschichtung eine Reinheit von wenigstens 99,999 % hat, und

- der elektrische Leiter, der den Metall-Kernleiter und die leitende Metallbeschichtung umfaßt, einen Außendurchmesser im Bereich von etwa 20 $\mu$m bis etwa 127 $\mu$m hat.

2. Verfahren zur Herstellung eines eines dünnen Draht aufweisenden elektrischen Leiters mit einem bestimmten Enddurchmesser, welches folgende Schritte umfaßt:

a) Bilden eines Metall-Kernleiters aus reinem Metall aus der Gruppe von Kupfer, Aluminium und Gold, mit einer Reinheit von wenigstens 99,99 %, wobei der Metall-Kernleiter einen Ausgangsdurchmesser aufweist,

b) Aufbringen einer leitenden Metallbeschichtung aus dem gleichen Metall wie das des Metall-Kernleiters, das eine höhere Reinheit als das Metall des Metall-Kernleiters hat, wobei die Reinheit wenigstens 99,999 % beträgt, auf den Metall-Kernleiter durch Ausscheiden aus der Dampfphase, um eine beschichteten Draht zu bilden, der einen zweiten Durchmesser hat, der größer als der Ausgangsdurchmesser des Metall-Kernleiters ist, und

c) Kaltverformen des beschichteten Drahtes zur plastischen Verringerung des Durchmessers des beschichteten Drahtes, um so eine prozentuale Verringerung der Querschnittsfläche des beschichteten Drahtes im Bereich von 20-90 % zu erzielen, um einen fertigen Draht herzustellen, der einen Enddurchmesser hat, der im Bereich von etwa 20 $\mu$m bis etwa 127 um liegt.

3. Verfahren nach Anspruch 2, wobei das Aufbringen der leitenden Metallbeschichtung und die Kaltverformungschritte im Wechsel mehrere Male durchgeführt werden.

**Revendications**

1. Conducteur électrique à fil fin comprenant un conducteur métallique central et un revêtement métallique conducteur sur ledit conducteur métallique central, dans lequel :

- ledit conducteur métallique central est en un métal sélectionné dans le groupe consistant en cuivre, aluminium et or;

- ledit revêtement métallique conducteur est du même métal que ledit conducteur métallique central et a une pureté plus élevée que ledit conducteur métallique central;

- ledit conducteur métallique central a une pureté d'au moins 99,99%;

- ledit revêtement métallique conducteur a une pureté d'au moins 99,999%; et

- ledit conducteur électrique comprenant le conducteur métallique central et le revêtement métallique conducteur a un diamètre extérieur compris dans le domaine d'environ 20 $\mu$m à environ 127 $\mu$m.

2. Procédé de production d'un conducteur électrique à fil fin ayant un diamètre final déterminé, comprenant les étapes de :

a) formation d'un conducteur métallique central de métal pur sélectionné dans le groupe consistant en cuivre, aluminium et or ayant une pureté d'au moins 99,99%, ledit conducteur métallique central ayant un diamètre initial;

b) déposition, par un procédé en phase vapeur sur ledit conducteur métallique central, d'un revêtement métallique conducteur du même métal que celui dudit conducteur métallique central, ayant une pureté plus élevée que le métal dudit conducteur métallique central, sa pureté étant d'au moins 99,999%, pour former un fil enrobé ayant un second diamètre qui est plus grand que ledit diamètre initial dudit conducteur métallique central; et

c) déformation à froid dudit fil enrobé pour une réduction plastique du diamètre dudit fil enrobé, réalisant par ce moyen une réduction en pourcentage de la superficie de la section du fil enrobé comprise dans le domaine de 20 à 90%, pour former un fil fini ayant ledit diamètre final qui est compris dans le domaine d'environ 20 $\mu$m à environ 127 $\mu$m.

3. Procédé comme exposé dans la revendication 2, dans lequel ladite étape de déposition dudit revêtement métallique conducteur et ladite étape de déformation à froid sont exécutées en alternance une pluralité de fois.

## FIG.1

## FIG.2

# FIG.3

101
102
103

# FIG.4

101
101
101

# FIG.5

104
106
105